# EUROPÄISCHE PATENTSCHRIFT

(11) **EP 3 471 518 B1**
(45) Veröffentlichungstag und Bekanntmachung des Hinweises auf die Patenterteilung: **26.02.2020**
(21) Anmeldenummer: 18194292.1
(22) Anmeldetag: 13.09.2018
(51) Int. Cl.: H05K 3/00, H05K 3/28, H01L 23/00, H01L 31/0203, H01L 31/167, H01L 21/56, H01L 23/31, H05K 3/34, H05K 1/18, B29C 45/14

(54) **VERFAHREN ZUR HERSTELLUNG VON OPTOELEKTRONISCHEN SENSOREN, INSBESONDERE VON MINIATURSENSOREN**
METHOD FOR PRODUCING OPTOELECTRONIC SENSORS, IN PARTICULAR MINIATURE SENSORS
PROCÉDÉ DE FABRICATION DE DÉTECTEURS OPTOÉLECTRONIQUES, EN PARTICULIER DE CAPTEURS MINIATURES

(30) Priorität: 10.10.2017 DE 102017123552
(43) Veröffentlichungstag der Anmeldung: 17.04.2019
(73) Patentinhaber: SICK AG, 79183 Waldkirch (DE)
(72) Erfinder: Edelmann, Georgy, 79194 Gundelfingen (DE)

(56) Entgegenhaltungen:
- WO-A1-2006/101274
- DE-A1-102009 059 236
- US-A1- 2007 004 095
- US-A1- 2015 043 228
- US-A1- 2015 262 984
- US-B1- 9 105 613

## Beschreibung

Die Erfindung betrifft ein Verfahren zur Herstellung von optoelektronischen Sensoren, vorzugsweise Miniatursensoren, bei welchem mehrere in einem Leiterplattennutzen verbundene Leiterplatten automatisch mit elektronischen Bauelementen bestückt werden, welche umspritzt und vereinzelt werden.

Aus der DE 10 2008 010 512 A1 ist ein Verfahren zur Herstellung eines optoelektronischen Bauteiles bekannt, wobei jedes optoelektronische Bauteil mindestens einen Halbleiterchip mit einer Chipunterseite sowie mit mindestens zwei elektrischen Kontaktierungen mit Kontaktunterseiten aufweist, wobei sich die Kontaktierungen an der Chipunterseite befinden. Der Halbleiterchip ist mit Ausnahme der Chipunterseite allseitig von einem Vergusskörper umgeben. Die Mehrzahl der Halbleiterchips wird auf einem Träger aufgebracht, der als eine streckbare Sägefolie ausgebildet ist. Durch das Strecken der Folie werden die Halbleiterchips voneinander separiert, so dass gleichmäßige laterale Abstände zwischen den Halbleiterchips auf der Folie entstehen. Danach werden die Halbleiterchips über ein Kompressionsmoldingverfahren umspritzt und anschließend vereinzelt. Die fertigen optoelektronischen Bauteile werden von der Folie nach der Vereinzelung entfernt.

Es wird immer schwieriger, optoelektronische Miniatursensoren auf konventionelle Art und Weise herzustellen. Da ein manuelles Handling der Sub-Miniaturbauteile kaum möglich ist, erfordert eine Einzelsensorfertigung komplexe und filigrane Hilfs- und Automatisierungsvorrichtungen. Dies hat die Folge, dass bei kleiner werdenden Dimensionen nicht eine erwartete Kostensenkung, sondern eine Steigerung der Herstellungskosten mit sich geht.

Die US20150262984A1 offenbart ein Wafer-Level-Packaging-Verfahren und optoelektronische Bauelemente, Gehäuse und Baugruppen, die mit dem eWLP-Verfahren hergestellt werden.

Die US9105613B1 offenbart ein Verfahren zum Herstellen eines elektronischen Packungsmoduls. Das Verfahren bildet eine zweiseitige und selektive Einkapselung unter Verwendung eines Dammfüllprozesses und einer Halbleiterschicht. Elektronische Komponenten sind vor elektromagnetischen Störungen geschützt, während die Funktion bestimmter elektronischer Komponenten, die nicht eingekapselt sind, nicht beeinträchtigt wird.

Die US20150043228A1 offenbart eine Halbleitervorrichtung, eine Platine, einen Controller-Chip, einen Halbleiterchip, einen Versiegelungsabschnitt und eine Komponente. Die Platine umfasst eine erste Oberfläche und eine zweite Oberfläche, die der ersten Oberfläche gegenüberliegt, wobei die erste Oberfläche einen Anschluss umfasst. Der Controller-Chip und der Halbleiterchip befindet sich auf der zweiten Oberfläche der Platine. Der Versiegelungsabschnitt bedeckt integral den Steuerchip und den Halbleiterchip und bedeckt keinen Bereich der zweiten Oberfläche der Platine.

Die US20070004095A1 offenbart das Bestücken einer Leiterplatte mit Bauteilen und das Einkapseln der Leiterplatte und der Bauteile mit einem Material. Das Verfahren umfasst ferner das Trennen der Leiterplatte in mehrere separate Vorrichtungen

Die DE102009059236A1 offenbart Verfahren zum Herstellen eines Bauelements, umfassend: Bereitstellen von mehreren Modulen, wobei jedes der Module einen Träger und mindestens einen an dem Träger angebrachten Halbleiterchip umfasst; Aufbringen einer dielektrischen Schicht auf den Modulen, um ein Werkstück auszubilden; Strukturieren der dielektrischen Schicht, um mindestens einen der Halbleiterchips zu öffnen und Vereinzeln des Werkstücks, um mehrere Bauelemente zu erhalten.

Die WO2006101274A1 offenbart eine Maske die an einer Leiterplatte angebracht ist, auf der mehrere Sensorpakete aufgeklebt sind. Eine Oberseite eines Deckglases jeder Sensorpackung ist durch einen Maskenabschnitt der Maske geschützt. Die Leiterplatte wird in eine Vakuumsiebdruckmaschine eingesetzt und mit einer Paste aus Versiegelungsharz beaufschlagt.

Der Erfindung liegt die Aufgabe zugrunde, ein Verfahren zur Herstellung von optoelektronischen Sensoren anzugeben, welches zur Fertigung von Miniatursensoren vollständig automatisch abläuft und auf komplexe Automatisierungsvorrichtungen verzichtet.

Erfindungsgemäß ist die Aufgabe dadurch gelöst, dass nach der Bestückung der einzelnen Leiterplatten des Leiterplattennutzens mit elektronischen Bauelementen optische und mechanische Bauelemente zum vollständigen Aufbau eines optoelektronischen Sensors auf jeder Leiterplatte des Leiterplattennutzens aufgebracht werden. Dies hat den Vorteil, dass es sich um ein sehr kostengünstiges Automationsverfahren handelt, da bei jedem Arbeitsschritt gleichzeitig eine Vielzahl von optoelektronischen Sensoren mit konventionellen Vorrichtungen bearbeitet wird. Die Miniaturisierung und das Handling der einzelnen optoelektronischen Sensoren werden dabei vereinfacht, da bis zum Abschluss des Herstellungsverfahrens der gesamte Leiterplattennutzen und nicht einzelne Miniaturbauteile behandelt werden.

Gemäß der Erfindung wird nach der Bestückung aller Leiterplatten des Leiterplattennutzens mit allen für den vollständigen Aufbau der Sensoren notwendigen Bauelementen der Leiterplattennutzen auf einem plattenförmigen Trägerelement befestigt. Das Trägerelement bildet dabei gleichzeitig eine Außenwandung des optoelektronischen Sensors.

In einer Ausgestaltung wird als plattenförmiges Trägerelement eine in Segmente unterteilte hochtemperaturbeständige Platte verwendet, auf welcher der bestückte Leiterplattennutzen so aufgesetzt wird, dass jede einen optoelektronischen Sensor tragende Leiterplatte ein vorgegebenes Segment der hochtemperaturbeständigen Platte ausfüllt. Die hochtemperaturbeständige Platte ist aus einem hochtemperaturbeständigen Werkstoff, beispielsweise einem Polymer oder einem Duroplast. Diese Werkstoffe können den Temperaturen in einem Lötofen, also einem SMD-Ofen während des SMD-Lötprozesses standhalten. Wenn das plattenförmige Trägerelement aus einem solchen spritzgussfähigen Werkstoff besteht wird, vorzugsweise der gleiche Kunststoff auch für die Umspritzung bzw. das Gehäuse verwendet, wodurch eine optimale Verbindung zwischen beiden gebildet wird.

In einer Ausgestaltung wird als plattenförmiges Trägerelement eine in Segmente unterteilte Metallplatte verwendet, auf welcher der bestückte Leiterplattennutzen so aufgesetzt wird, dass je eine einen optoelektronischen Sensor tragende Leiterplatte ein vorgegebenes Segment der Metallplatte ausfüllt. Die Segmente lassen sich einfach durch einen Stanzvorgang in der Metallplatte ausbilden. Dadurch wird die Herstellung von Miniatursensoren weiter vereinfacht.

In einer Variante wird der Leiterplattennutzen in ein zwei Formhälften aufweisendes Spritzgusswerkzeug eingelegt, wobei beim Schließen der Formhälften des Spritzgusswerkzeuges die die optoelektronischen Sensoren tragenden Leiterplatten als Sensormodule vereinzelt werden. Dabei wird zum Vereinzeln der Leiterplatten kein eigenständiges Werkzeug benötigt, sondern ein an sich vorhandenes Spritzgusswerkzeug wird genutzt, wodurch die Herstellungskosten weiter reduziert werden.

In einer Ausführungsform werden die vereinzelten Sensormodule in dem Spritzgusswerkzeug umspritzt. Dadurch entstehen die umspritzten Sensormodule, ohne dass sie vorher einzeln in das Spritzgusswerkzeug eingelegt werden müssen. Dies trägt zur weiteren Senkung der Herstellungskosten bei.

Vorteilhafterweise bleibt die Metallplatte bzw. die hochtemperaturbeständige Platte des Sensormoduls unumspritzt. Damit kann die Metallplatte bzw. die hochtemperaturbeständige Platte einfach am Anwendungsort des Sensors mit anderen Bauteilen verbunden werden.

Gemäß der Erfindung wird die Metallplatte bzw. die hochtemperaturbeständige Platte vor der Umspritzung zur Bildung wenigstens einer Seitenwandung des Sensormoduls gestanzt oder gebogen. Durch eine solche Seitenwandung wird die Steifigkeit des Sensormoduls verbessert.

In einer Ausführungsform wird vor der Umspritzung an jedem Sensormodul eine Leitung kontaktiert, wobei die Leitungen jeweils von dem Leiterplattennutzen ? weg gerichtet sind. Durch diese Ausrichtung der Leitungen wird die weitere Bearbeitung der Sensormodule im Spritzgusswerkzeug nicht behindert.

Vorteilhafterweise werden Anschluss- und Elektrokontaktierelemente mittels SMD-Technologie auf den Leiterplatten des Leiterplattennutzens aufgebracht. Mittels dieser SMD-Technik wird eine geläufige und kostengünstige Technik zur Montage der elektronischen Bauelemente bzw. der Anschluss- und Elektrokontaktierelemente verwendet.

Die Erfindung lässt zahlreiche Ausführungsformen zu. Eine davon soll anhand der in der Zeichnung dargestellten Figuren näher erläutert werden.

Es zeigen:
- Fig. 1: ein erstes Ausführungsbeispiel des erfindungsgemäßen Verfahrens,
- Fig. 2: ein zweites Ausführungsbeispiel des erfindungsgemäßen Verfahrens.

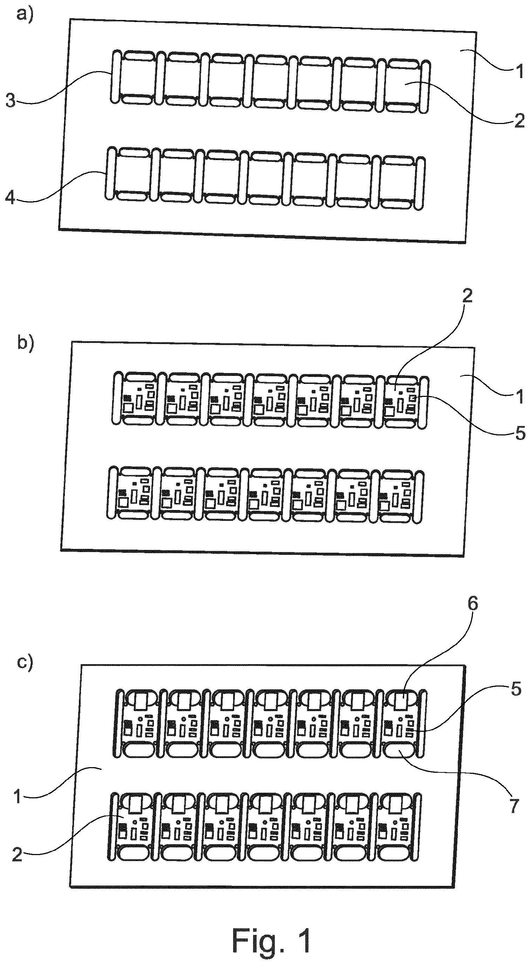

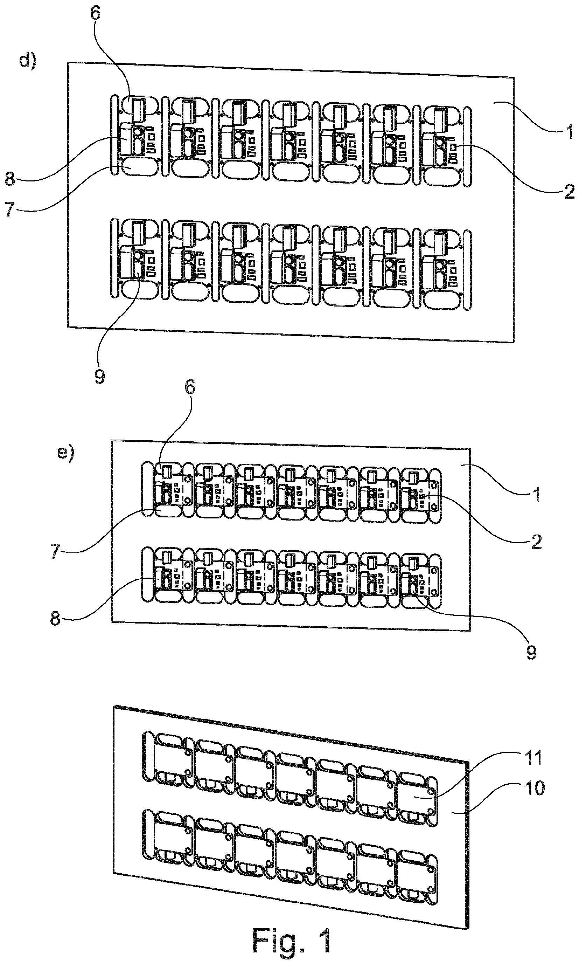

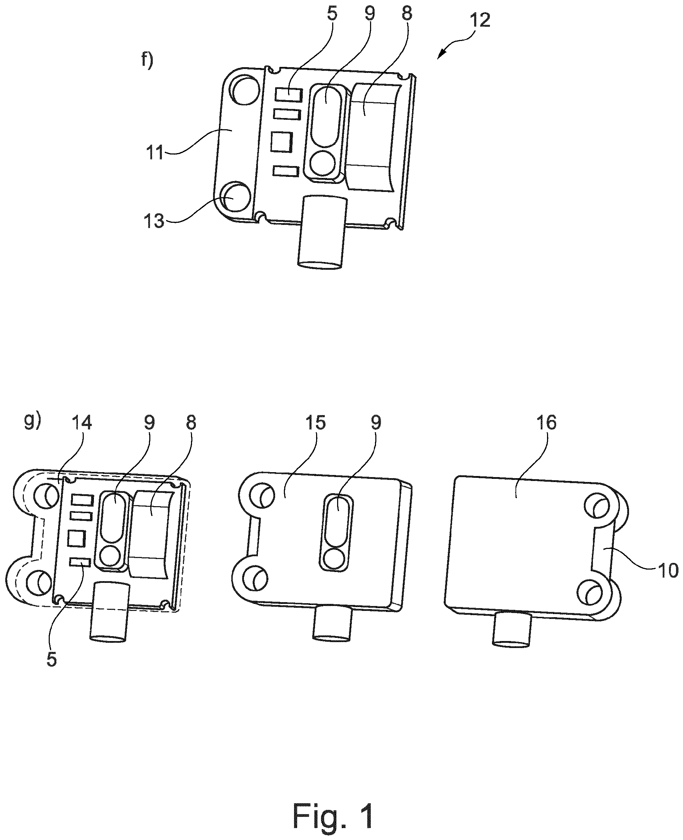

In Fig. 1 ist ein Ausführungsbeispiel des erfindungsgemäßen Verfahrens dargestellt. Mittels dieses Verfahrens soll gleichzeitig ein kompletter Aufbau von mehreren optoelektronischen Sensoren gewährleistet werden. Als Basis für die komplette Sensorfertigung dient dabei ein Leiterplattennutzen 1, welcher in Fig. 1a gezeigt ist. Der Leiterplattennutzen 1 stellt einen Verbund von mehreren Leiterplatten 2 dar, die noch nicht vereinzelt sind. In diesem Fall sind zwei parallel zueinander verlaufende Leiterplattenreihen 3, 4 in dem Leiterplattennutzen 1 angeordnet.

In einem sich anschließenden Schritt (Fig. 1b) wird die Sensorelektronik 5 auf jeder Leiterplatte 2 des Leiterplattennutzens 1 auf einer SMD-Linie bestückt. Dabei wird die Sensorelektronik 5 auf jeder einzelnen Leiterplatte 2 aufgebracht. In einem anschließenden Schritt (Fig. 1c) werden Anschluss- und Elektronikkontaktierelemente 6 bzw. 7, wie beispielsweise SMD-bestückbare Stecker oder Leitungskontaktierungsschnittstellen, wie bestückbare Krallen und ähnliches aufgebracht.

Wie aus Fig. 1d hervorgeht, werden bei einem Durchlauf durch eine Pick - and Place-Anlage oder alternativ wieder durch SMD-Technologie die optischen Bauelemente 9 und die mechanischen Bauteile 8 auf den Leiterplatten 2 bestückt. Die Befestigung der einzelnen optischen Bauelemente 9 und der mechanischen Bauteile 8 kann dabei beispielsweise durch mechanische Schnappelemente, Verdrängungsrippen oder thermisch aushärtendem Klebstoff erfolgen.

Im darauffolgenden Schritt erfolgt eine flächige Verbindung des gesamten vorbestückten Leiterplattennutzens 1 mit einem plattenförmigen Träger 10, wie es in Fig. 1e gezeigt ist. Der plattenförmige Träger 10 ist als gestanztes Metallblech ausgebildet, wobei der Leiterplattennutzen 1 so auf dem Metallblech aufgebracht wird, dass die einzelnen Leiterplatten 2 auf vorgefertigten Segmenten 11 des Metallblechs genau platziert werden.

Der durch das Metallplattenmaterial verstärkte Leiterplattennutzen 1 wird in ein Spritzgusswerkzeug eingelegt (Fig. 1f). Beim Schließen des aus zwei Formhälften bestehenden Spritzgusswerkzeuges werden die dünnen Verbindungsstege der einzelnen Leiterplatten 2 abgestanzt, so dass einzelne Sensormodule 12 entstehen, da die einzelnen Leiterplatten 2 vom Leiterplattennutzen 1 getrennt werden. Die so getrennten Sensormodule 12 werden in einzelnen Hohlräumen des Spritzguss-werkzeuges fixiert und mit einem gewünschten Gehäuse oder Werkstoff umspritzt. Dabei wird, wie aus Fig. 1g hervorgeht, die die elektronischen und optischen Bauelemente 5, 9 tragende Oberfläche der Leiterplatte 2 mit einem transparenten Werkstoff umspritzt. Es besteht aber auch die Möglichkeit, dass nur das optische Bauelement 9 mit einer transparenten Beschichtung versehen wird, während alle anderen Bauelemente mit einer untransparenten Abdeckung 15 bedeckt werden. In einer weiteren Alternative ist die Außenwandung des Sensormoduls 12 vollständig mit der Umspritzung 16 bedeckt.

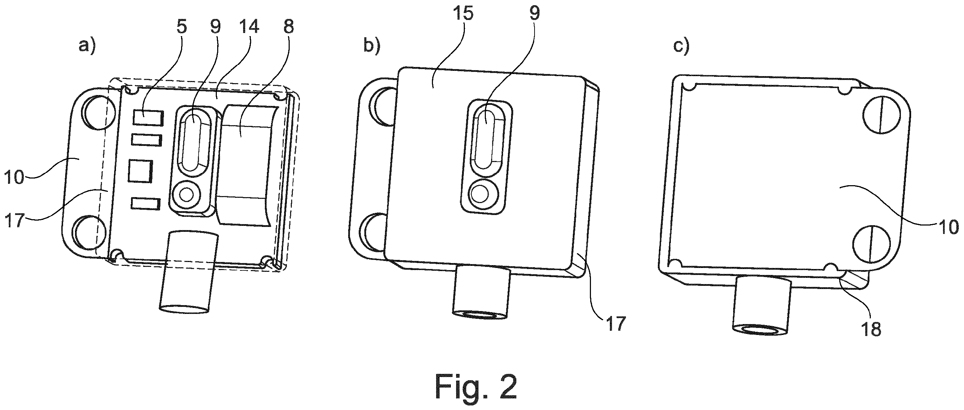

Wie in Fig. 2 gezeigt, wird vor dem Umspritzen noch ein weiterer Verfahrensschritt eingelegt, bei welchem die Segmente 11 der Metallplatte 10 gestanzt und gebogen werden, so dass Seitenwandungen 17 zur Erhöhung der Steifigkeit des Sensormoduls 12 ausgebildet werden. In diesem Fall bleibt die segmentförmige Metallplatte 11 frei von der Umspritzung. Für etwaige Leitungsvarianten muss vor der Umspritzung die Leitung kontaktiert werden. Aufgrund der Anordnung von zwei Leiterplattenreihen 3, 4, die sich auf dem Leiterplattennutzen 1 gegenüberstehen, wird eine Ausbildung der Leitungen von dem Leiterplattennutzen 1 weg gewählt. Diese an der Leiterplatte 2 befestigten Leitungen werden bei der Umspritzung mit umspritzt.

Die vorliegende Lösung ermöglicht eine einfache Automatisierbarkeit bei der Herstellung von Miniatursensoren unter Nutzung der verbreiteten SMD- bzw. Pickand Place-Technologien ohne die Verwendung von hochkomplexen Vorrichtungen.

## Patentansprüche

1. Verfahren zur Herstellung von optoelektronischen Sensoren, vorzugsweise Miniatursensoren, bei welchem mehrere in einem Leiterplattennutzen (1) verbundene Leiterplatten (2) automatisch mit elektronischen Bauelementen (5) bestückt werden, wobei nach der Bestückung der einzelnen Leiterplatten (2) des Leiterplattennutzens (1) mit elektronischen Bauelementen (5) optische und mechanische Bauelemente (9, 8) zum vollständigen Aufbau eines optoelektronischen Sensors auf jeder Leiterplatte (2) des Leiterplattennutzens (1) aufgebracht werden, welche umspritzt und vereinzelt werden, wobei nach der Bestückung aller Leiterplatten (2) des Leiterplattennutzens (1) mit allen für den vollständigen Aufbau der Sensoren notwendigen Bauelementen (5, 6, 7, 8, 9) der Leiterplattennutzen (1) auf einem plattenförmigen Trägerelement (10) befestigt wird, wobei als plattenförmiges Trägerelement (10) eine in Segmente (11) unterteilte hochtemperaturbeständige Platte oder Metallplatte verwendet wird, auf welcher der bestückte Leiterplattennutzen (1) so aufgesetzt wird, dass jede einen optoelektronischen Sensor tragende Leiterplatte (2) ein vorgegebenes Segment (11) der hochtemperaturbeständigen Platte oder Metallplatte ausfüllt, **dadurch gekennzeichnet, dass** die Metallplatte (10) oder die hochtemperaturbeständige Platte vor der Umspritzung zur Bildung wenigstens einer Seitenwandung (17) des Sensormoduls (12) gestanzt oder gebogen wird.

2. Verfahren nach mindestens einem der vorhergehenden Ansprüche, **dadurch gekennzeichnet, dass** der Leiterplattennutzen (1) in ein zwei Formhälften aufweisendes Spritzgusswerkzeug eingelegt wird, wobei beim Schließen der Formhälften des Spritzgusswerkzeuges die die optoelektronischen Sensoren tragenden Leiterplatten (2) als Sensormodule (12) vereinzelt werden.

3. Verfahren nach Anspruch 2, **dadurch gekennzeichnet, dass** die vereinzelten Sensormodule (12) in dem Spritzgusswerkzeug umspritzt werden.

4. Verfahren nach Anspruch 1, **dadurch gekennzeichnet, dass** die Metallplatte (10) oder die hochtemperaturbeständige Platte des Sensormoduls (12) unumspritzt bleibt.

5. Verfahren nach mindestens einem der vorhergehenden Ansprüche, **dadurch gekennzeichnet, dass** vor der Umspritzung an jedem Sensormodul (12) eine Leitung kontaktiert wird, wobei die Leitungen der Sensormodule (12) jeweils von dem Leiterplattennutzen (1) weg gerichtet sind.

6. Verfahren nach mindestens einem der vorhergehenden Ansprüche, **dadurch gekennzeichnet, dass** Anschluss- und Elektrokontaktierelemente (6, 7) mittels SMD-Technologie auf dem Leiterplattennutzen (1) vor dessen Vereinzelung aufgebracht werden.

7. Verfahren nach mindestens einem der vorhergehenden Ansprüche, **dadurch gekennzeichnet, dass** die elektronischen Bauelemente (5) mittels einer SMD-Technologie auf die Leiterplatten (2) des Leiterplattennutzens (1) aufgebracht werden.

## Claims

1. A method of manufacturing optoelectronic sensors, preferably miniature sensors, in which a plurality of circuit boards (2) connected in a circuit board panel (1) are automatically mounted with electronic components (5), wherein, after the mounting of the individual circuit boards (2) of the circuit board panel (1) with electronic components (5), optical and mechanical components (9, 8) that are overmolded and separated are attached to each circuit board (2) of the circuit board panel (1) for a complete setup of an optoelectronic sensor; wherein, after the mounting of all the circuit boards (2) of the circuit board panel (1) with all the components (5, 6, 7, 8, 9) required for the complete setup, the circuit board panel (1) is fastened to a board-like carrier element (10); and wherein a high temperature resistant board or a metal plate is used as the board-like carrier element (10) which is divided into segments (11) and on which the mounted circuit board panel (1) is placed such that every circuit board carrying an optoelectronic sensor fills up a predefined segment (11) of the high temperature resistant board or metal plate, **characterized in that** the metal plate (10) or the high temperature resistant board is stamped or bent before the overmolding to form at least one side wall (17) of the sensor module (12).

2. A method in accordance with claim 1, **characterized in that** the circuit board panel (1) is placed into an injection molding tool having two mold halves, with the circuit boards (2) carrying the optoelectronic sensors being separated as sensor modules (12) on the closing of the mold halves of the injection molding tool.

3. A method in accordance with claim 2, **characterized in that** the separated sensor modules (12) are overmolded in the injection molding tool.

4. A method in accordance with claim 1, **characterized in that** the metal plate (10) or the high temperature resistant board of the sensor module (12) remains without overmolding.

5. A method in accordance with at least one of the preceding claims, **characterized in that** a line is contacted at every sensor module (12) before the overmolding, with the lines of the sensor modules (12) each being directed away from the circuit board panel (1).

6. A method in accordance with at least one of the preceding claims, **characterized in that** connector elements and electrical contact elements (6. 7) are applied to the circuit board panel (2) by means of SMD technology before its separation.

7. A method in accordance with at least one of the preceding claims, **characterized in that** the electronic components (5) are applied to the circuit boards (2) of the circuit board panel (1) by means of an SMD technology.

## Revendications

1. Procédé de réalisation de capteurs optoélectroniques, de préférence de capteurs miniatures, dans lequel plusieurs cartes à circuits imprimés (2) reliées dans un flan à circuits imprimés (1) sont automatiquement équipées de composants électroniques (5), une fois que les cartes à circuits imprimés (2) individuelles du flan à circuits imprimés (1) sont équipées des composants électroniques, des composants optiques et mécaniques (9, 8) pour l'assemblage complet d'un capteur optoélectronique sont appliqués sur chaque carte à circuits imprimés (2) du flan à circuits imprimés (1), qui sont surmoulés et individualisés, une fois que toutes les cartes à circuits imprimés (2) du flan à circuits imprimés sont équipées de tous les composants (5, 6, 7, 8, 9) nécessaires pour l'assemblage complet des capteurs, le flan à circuits imprimés (1) est fixé sur un élément porteur (10) en forme de plaque, à titre d'élément porteur (10) en forme de plaque sert une plaque ou plaque métallique résistante aux hautes températures, subdivisée en segments (11), sur laquelle le flan à circuits imprimés (1) équipé est placé de telle sorte que chaque carte à circuits imprimés (2) portant un capteur optoélectronique remplit un segment prédéterminé (11) de la plaque ou plaque métallique résistante aux hautes températures, **caractérisé en ce qu'**avant le surmoulage, la plaque métallique (10) ou la plaque résistante aux hautes températures est découpée ou pliée pour former au moins une paroi latérale (17) du module capteur (12).

2. Procédé selon la revendication précédente, **caractérisé en ce que** le flan à circuits imprimés (1) est posé dans un outil de moulage par injection comportant deux moitiés de moule, et lors de la fermeture des moitiés de moule de l'outil de moulage par injection, les cartes à circuits imprimés (2) portant les capteurs optoélectroniques sont individualisées en modules capteurs (12).

3. Procédé selon la revendication 2, **caractérisé en ce que** les modules capteurs (12) individualisés sont surmoulés dans l'outil de moulage par injection.

4. Procédé selon la revendication 1, **caractérisé en ce que** la plaque métallique (10) ou la plaque résistante aux hautes températures du module capteur (12) reste sans être surmoulée.

5. Procédé selon l'une au moins des revendications précédentes, **caractérisé en ce qu'**avant le surmoulage, un fil est mis en contact sur chaque module capteur (12), les fils des modules capteurs (12) étant chacun détournés du flan à de circuits imprimés (1).

6. Procédé selon l'une au moins des revendications précédentes, **caractérisé en ce que** des éléments de connexion et de contact électrique (6, 7) sont appliqués sur le flan à circuits imprimés (1) à l'aide de la technologie CMS, avant de l'individualiser.

7. Procédé selon l'une au moins des revendications précédentes, **caractérisé en ce que** les composants électroniques (5) sont appliqués sur les cartes à circuits imprimés (2) du flan à circuits imprimés (1) à l'aide d'une technologie CMS.
